# FASCICULE DE BREVET EUROPEEN

(11) **EP 2 600 462 B1**
(45) Date de publication et mention de la délivrance du brevet: **03.06.2015**
(21) Numéro de dépôt: 12193821.1
(22) Date de dépôt: 22.11.2012
(51) Int. Cl.: G01R 31/36, G01R 19/10, H01M 10/052, H01M 10/42, H02J 7/00

(54) **Procédé d'équiblibrage des tensions d'éléments électrochimiques disposés dans plusieurs branches en parallèle**
Verfahren zum Ausgleich von Spannungen elektrischer Elemente, die auf mehreren parallelen Zweigen angeordnet sind
Method for balancing the voltages of electrochemical cells arranged in a plurality of parallel arms

(30) Priorité: 29.11.2011 FR 1160918
(43) Date de publication de la demande: 05.06.2013
(73) Titulaire: SAFT, 93170 Bagnolet (FR)
(72) Inventeur: Maloizel, Serge, 16730 Trois Palis (FR); Perot, Antoine, 33520 Bruges (FR)
(74) Mandataire: Hirsch & Associés

(56) Documents cités:
- EP-A2- 2 075 894
- EP-A2- 2 590 297
- US-A1- 2011 074 354

## Description

### DOMAINE TECHNIQUE

L'invention concerne le domaine des procédés d'équilibrage des tensions des éléments électrochimiques constituant une batterie. L'invention concerne également les systèmes électroniques permettant la mise en oeuvre de tels procédés d'équilibrage, ainsi qu'un produit de programme d'ordinateur et un support d'information lisible par un ordinateur.

### ETAT DE LA TECHNIQUE

Une batterie comprend généralement une pluralité d'éléments électrochimiques (encore appelés éléments) qui constituent chacun un dispositif de production d'électricité dans lequel de l'énergie chimique est convertie en énergie électrique. L'énergie chimique est constituée par des composés électrochimiquement actifs déposés sur au moins une face d'électrodes disposées dans l'élément. L'énergie électrique est produite par des réactions électrochimiques au cours d'une décharge de l'élément. Les électrodes, disposées dans un conteneur, sont connectées électriquement à des bornes de sortie de courant qui assurent une continuité électrique entre les électrodes et un consommateur électrique auquel l'élément est associé. La quantité d'énergie électrique que peut fournir un élément électrochimique se mesure par la capacité exprimée en ampère heure multipliée par sa tension exprimée en volt.

Une batterie peut être divisée en modules, chaque module étant composé d'une pluralité d'éléments reliés entre eux en série et/ou en parallèle et réunis dans un même bac. La batterie est destinée à fournir de l'énergie électrique à une application extérieure. Un circuit de charge est généralement prévu auquel la batterie peut être branchée pour recharger les éléments. Un système de gestion comportant des capteurs de mesure et un circuit électronique de contrôle plus ou moins évolué selon les applications peut être associé à la batterie. Un des rôles du système de gestion est de mesurer la tension des éléments électrochimiques et d'en déduire l'état de charge desdits éléments. On rappelle que l'état de charge (SOC « state of charge » en anglais) est le ratio de la capacité chargée par rapport à la capacité nominale qui peut être fournie par l'élément électrochimique. Il s'exprime en pourcentage et reflète la part d'énergie restante disponible pour l'utilisateur. Si l'état de charge d'un des éléments est en dehors d'une plage prédéterminée, cela peut traduire un dysfonctionnement de l'élément. Le circuit électronique de contrôle interrompt alors la charge ou la décharge de l'élément de manière à éviter qu'il ne fasse l'objet de surcharges ou de fortes décharges de nature à réduire ses performances mais surtout à limiter sa durée de vie.

La mesure de la tension (à vide ou en décharge à faible courant) d'un élément électrochimique de type lithium-ion peut fournir une indication sur l'état de charge de cet élément. En effet, un élément électrochimique de type lithium-ion présente une variation de la tension en fonction du temps qui est sensiblement constante en fonction de son état de charge pour un courant de décharge donné. Il est donc possible pour ce type d'élément d'établir une relation de proportionnalité entre l'état de charge et la tension. Or, en raison d'une dispersion des autodécharges des éléments électrochimiques pouvant par exemple résulter de variations dans le procédé de fabrication desdits éléments (impureté dans les éléments pouvant entrainer des courants de fuite, etc.), plusieurs éléments électrochimiques d'une même batterie peuvent avoir des tensions différentes donc des états de charge différents. On rappelle que l'autodécharge est le phénomène par lequel un élément électrochimique perd de la capacité bien que celui-ci n'alimente pas le consommateur électrique. Cette perte de capacité est due à une fuite de courant interne à l'élément, qui se produit entre les électrodes de l'élément.

L'équilibrage est une technique qui consiste à amener les tensions de différents éléments électrochimiques à la même valeur. Il peut s'agir de procédés d'équilibrage dits « actifs » lorsqu'ils utilisent l'énergie des éléments les plus chargés pour la transférer vers les éléments les moins chargés à l'aide d'un système utilisant par exemple des bobines, des transformateurs ou des condensateurs. Il peut s'agir de procédés d'équilibrage dits « passifs » lorsque l'on décharge un élément plus chargé jusqu'à ce que sa tension atteigne la tension d'un élément moins chargé, sans transférer d'énergie de l'élément plus chargé vers l'élément moins chargé. Une fois la batterie équilibrée, les éléments électrochimiques ont tous le même état de charge.

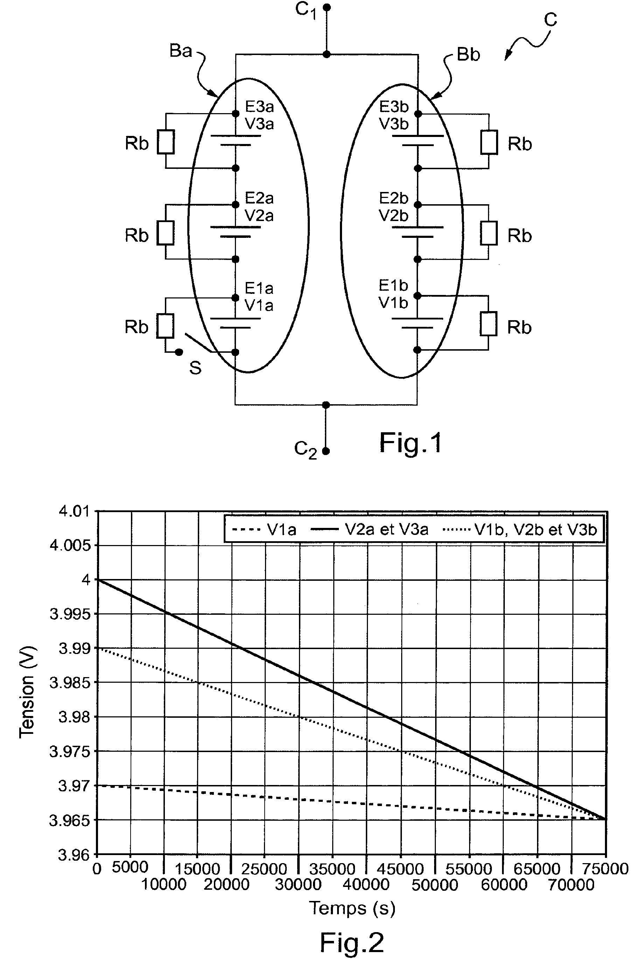

Une batterie peut comporter plusieurs branches parallèles d'éléments connectés en série. Certains des éléments connectés en série peuvent être regroupés au sein d'un même bac formant un module. La figure 1 représente une batterie C constituée de deux branches Ba, Bb connectées en parallèle aux points de connections C1 et C2 à un chargeur ou à une application non représentés. Chaque branche comprend une pluralité d'éléments électrochimiques. La branche Ba comprend trois éléments électrochimiques E1a, E2a, E3a connectés en série et aux bornes desquelles on mesure les tensions V1a, V2a, V3a. La branche Bb comprend trois éléments électrochimiques E1b, E2b, E3b connectés en série et aux bornes desquelles on mesure les tensions V1b, V2b, V3b. Une des méthodes d'équilibrage consiste à connecter pendant la phase d'équilibrage une résistance Rb, appelée résistance d'équilibrage, en parallèle sur tous les éléments électrochimiques excepté celui qui a la tension la plus faible. Un interrupteur S à l'état ouvert empêche la décharge de l'élément E1a dans la résistance Rb. Le principe de cet équilibrage consiste à transformer en chaleur l'excès d'énergie contenu dans les éléments électrochimiques les plus chargés pour que ceux-ci atteignent le même état de charge que l'élément électrochimique le moins chargé.

Dans l'exemple de la figure 1, les éléments E2a, E3a, E1b, E2b et E3b possèdent une tension plus élevée que celle de l'élément E1a. E1a est donc l'élément électrochimique possédant l'état de charge le plus faible. Une résistance Rb est connectée aux bornes des éléments E2a, E3a, E1b, E2b et E3b.

La figure 2 représente la variation des tensions au cours de l'équilibrage. Avant équilibrage, les tensions V1a, V2a, V3a sont respectivement de 3,97 ; 4 et 4 V. Avant équilibrage, les tensions V1b, V2b, V3b sont identiques et égales à 3,99 V. Après équilibrage, les tensions sont identiques et valent 3,965 V. On constate que pendant que les éléments électrochimiques de la branche Bb baissent de 25 mV, les éléments électrochimiques à tension haute de la branche Ba baissent de 35 mV et l'élément électrochimique ayant la tension la plus basse de la branche Ba baisse de 5 mV. De manière générale, plus le nombre d'éléments électrochimiques dans la branche est grand, plus la baisse de tension de l'élément électrochimique ayant la tension la plus basse est faible.

L'inconvénient de cette méthode est que pendant la phase d'équilibrage, l'élément électrochimique qui a la tension la plus faible peut subir une légère décharge bien qu'il n'ait pas de résistance d'équilibrage connectée en parallèle. Cette légère décharge provient du fait que la loi des noeuds doit être respectée. En effet, V1a + V2a + V3a doit rester égal à V1b + V2b + V3b. Supposons que V1a, V2a, V3a, V1b, V2b et V3b soient égaux à 4 V et que l'on branche des résistances en parallèle sur V2a, V3a, V1b, V2b et V3b, il résulte que V1a va également baisser.

Le problème de la légère décharge que subit l'élément à équilibrer ne peut pas être résolu par la simple mise en place d'un interrupteur en série avec l'élément le moins chargé. En effet, cela requiert d'une part d'utiliser un interrupteur de puissance capable de laisser passer les courants d'utilisation de la branche avec cet élément et d'autre part, on ne pourrait plus équilibrer pendant les phases d'utilisation (charge ou décharge) de la batterie mais seulement pendant les phases de repos.

Le document US-A-2011/0074354 décrit un procédé selon l'état de la technique.

Il existe donc un besoin pour un procédé d'équilibrage dans lequel l'élément électrochimique devant être équilibré ne subit plus de décharge durant l'équilibrage, ceci afin d'améliorer en outre l'efficacité énergétique.

### RESUME DE L'INVENTION

L'invention est basée sur la découverte que lors de l'équilibrage d'une batterie comprenant une pluralité de branches en parallèle, il est particulièrement avantageux de ne pas décharger tous les éléments ayant une tension supérieure à la tension de l'élément le moins chargé quelle que soit leur position dans les branches, et de ne décharger que les éléments les plus chargés de la branche qui possède l'élément le moins chargé. Le système d'équilibrage dans la branche peut être de type décharge dans un dispositif de décharge des éléments les plus chargés ou de type transfert d'énergie des éléments les plus chargés vers les éléments les moins chargés à travers un dispositif de transfert d'énergie.

L'invention propose un procédé d'équilibrage d'une batterie (C) comprenant une pluralité de branches (Ba, Bb,... , Bn en nombre non limité à une valeur particulière) en parallèle, chaque branche comprenant au moins deux éléments électrochimiques en série (E1a, E2a, E3a, E1b, E2b, E3b,..., E1n E2n, E3n), un dispositif de décharge ou de transfert d'énergie électrique (Rb) activable, connecté aux bornes de chaque élément électrochimique, ledit procédé comprenant les étapes successives suivantes :
a) mesure de la tension aux bornes de chaque élément électrochimique (V1a, V2a, V3a, V1b, V2b, V3b,..., V1n, V2n, V3n) dans une configuration où tous les dispositifs de décharge ou de transfert d'énergie électrique ne sont pas activés ;
b) détermination de la tension la plus faible et de la tension la plus forte parmi l'ensemble des tensions mesurées à l'étape a);
c) calcul de la différence ΔV entre la tension la plus faible et la tension la plus forte de l'étape b);
d) si ΔV est supérieur à une valeur seuil prédéterminée ΔVs1 :
   - activation du ou des dispositif(s) de décharge ou de transfert d'énergie électrique connectés aux bornes du ou des élément(s) électrochimique(s) de la branche comprenant l'élément électrochimique possédant la tension la plus faible, à l'exception du dispositif de décharge ou de transfert d'énergie électrique associé à l'élément électrochimique ayant la tension la plus faible, simultanément avec :
   - désactivation des dispositifs de décharge ou de transfert d'énergie électrique connectés aux bornes des éléments électrochimiques du ou (des) branche(s) ne comprenant pas l'élément électrochimique ayant la tension la plus faible ;
e) mesure de la tension aux bornes de chaque élément électrochimique ;
f) détermination de la tension la plus faible et de la tension la plus forte parmi l'ensemble des tensions mesurées à l'étape e);
g) calcul de la différence entre la tension la plus faible et la tension la plus forte ΔV ;
h) si ΔV est inférieur à une valeur seuil prédéterminée ΔVs2, strictement inférieure à ΔVs1, désactivation de tous les dispositifs de décharge ou de transfert d'énergie électrique.

Dans le cadre de la présente invention, on entend par « dispositif de décharge » tout dispositif de faire baisser l'état de charge d'un élément électrochimique, notamment une résistance. On entend par « dispositif de transfert d'énergie électrique » tout dispositif permettant de recevoir de l'énergie électrique d'un premier élément électrochimique et de transmettre celle-ci à un second élément électrochimique. Il peut comprendre une première bobine connectée aux bornes d'un premier élément et une seconde bobine connectée aux bornes d'un second élément. La décharge du premier élément entraine le passage de courant dans la première bobine, ce qui crée un champ magnétique. Un courant induit par le champ magnétique est créé dans la deuxième bobine couplée à la première bobine. Si cette seconde bobine est connectée aux bornes d'un second élément électrochimique, le courant induit dans la deuxième bobine recharge le deuxième élément électrochimique. Le dispositif de transfert de l'énergie électrique peut également être un condensateur qui reçoit dans un premier temps de l'énergie électrique d'un premier élément et la transmet à un second élément électrochimique.

Le terme « activation du dispositif de décharge ou de transfert d'énergie électrique» signifie que l'on fait circuler un courant dans le dispositif de décharge ou de transfert d'énergie électrique. Dans le cas où le dispositif de décharge est une résistance, l'activation se produit par la fermeture du circuit électrique par un interrupteur ou un transistor. Dans le cas où le dispositif de transfert d'énergie comprend deux bobines, l'activation se produit par passage du courant dans une première bobine créant un champ magnétique qui induit le passage de courant dans une seconde bobine. Dans le cas où le dispositif de transfert d'énergie est un condensateur, l'activation se produit par stockage de la charge électrique provenant d'un premier élément dans le condensateur et restitution de la charge électrique à un second élément.

Le terme « désactivation du dispositif de décharge ou de transfert d'énergie électrique» signifie que l'on interrompt la circulation du courant dans le dispositif de décharge ou de transfert d'énergie électrique. Dans le cas où le dispositif de décharge est une résistance, la désactivation se produit par ouverture du circuit électrique à l'aide d'un interrupteur ou d'un transistor. Dans le cas où le dispositif de transfert d'énergie est constitué de bobines ou d'un condensateur, la désactivation se produit par interruption du passage du courant dans les bobines ou le condensateur.

Selon un mode de réalisation, le procédé comprend le suivi au cours du temps de la différence entre la tension la plus faible et la tension la plus forte et si cette différence ΔV est supérieure à ΔVs2 répétition des étapes d) à h).

Selon un mode de réalisation, l'activation du ou des dispositif(s) de décharge est obtenue à l'aide d'un interrupteur ou d'un transistor.

Selon un mode de réalisation, le dispositif de décharge est une résistance.

Selon un mode de réalisation, le dispositif de transfert de l'énergie électrique est choisi parmi une bobine et un condensateur.

Selon un mode de réalisation, au moins un élément électrochimique est au lithium, en particulier de type lithium-ion ou de type lithium polymère.

L'invention a également pour objet une batterie comprenant :
- une pluralité de branches (Ba, Bb,..., Bn) en parallèle, chaque branche comprenant au moins deux éléments électrochimiques en série (E1a, E2a, E3a, E1b, E2b, E3b, ..., E1n, E2n, E3n) ;
- un dispositif de décharge ou de transfert d'énergie électrique (Rb) activable, connecté aux bornes de chaque élément électrochimique ;
- un dispositif de mesure de la tension de chaque élément électrochimique (V1a, V2a, V3a, V1b, V2b, V3b, ..., V1n, V2n, V3n) ;
- un processeur configuré pour réaliser les étapes successives suivantes:
   a) mesurer la tension aux bornes de chaque élément électrochimique dans une configuration où tous les dispositifs de décharge ou de transfert d'énergie électrique ne sont pas activés ;
   b) déterminer la tension la plus faible et la tension la plus forte parmi l'ensemble des tensions mesurées à l'étape a);
   c) calculer la différence ΔV entre la tension la plus faible et la tension la plus forte de l'étape b);
   d) si ΔV est supérieur à une valeur seuil prédéterminée ΔVs1 :
      - activer un ou des dispositif(s) de décharge ou de transfert d'énergie électrique connectés aux bornes du ou des élément(s) électrochimique(s) de la branche comprenant l'élément électrochimique possédant la tension la plus faible à l'exception du dispositif de décharge ou de transfert d'énergie électrique associé à l'élément électrochimique ayant la tension la plus faible, simultanément avec :
      - désactiver des dispositifs de décharge ou de transfert d'énergie électrique connectés aux bornes des éléments électrochimiques du ou (des) branche(s) ne comprenant pas l'élément électrochimique ayant la tension la plus faible ;
   e) mesurer la tension aux bornes de chaque élément électrochimique ;
   f) déterminer la tension la plus faible et la tension la plus forte parmi l'ensemble des tensions mesurées à l'étape e);
   g) calculer la différence entre la tension la plus faible et la tension la plus forte ΔV ;
   h) si ΔV est inférieur à une valeur seuil prédéterminée ΔVs2 strictement inférieure à ΔVs1 désactiver tous les dispositifs de décharge ou de transfert d'énergie électrique.

Selon un mode de réalisation, le processeur est configuré pour suivre au cours du temps la différence entre la tension la plus faible et la tension la plus forte et si cette différence ΔV est supérieure à ΔV2s, répéter les étapes d) à h) du procédé, à l'exception du fait que l'étape d) ne comprend plus la comparaison de ΔV avec la valeur seuil prédéterminée ΔV1s.

Selon un mode de réalisation, au moins un élément électrochimique est au lithium, en particulier de type lithium-ion ou de type lithium polymère.

L'invention a également pour objet un produit de programme d'ordinateur comprenant au moins une séquence d'instructions stockées et accessibles à un processeur, où l'exécution de ladite au moins une séquence d'instructions conduit à la mise en oeuvre des étapes du procédé.

L'invention a également pour objet un support d'informations lisibles par un ordinateur, permettant de mettre en oeuvre au moins une des séquences d'instructions du produit de programme d'ordinateur.

### BREVE DESCRIPTION DES FIGURES

La figure 1 représente la mise en oeuvre d'un système d'équilibrage selon l'art antérieur dans lequel une batterie C comprend deux branches Ba et Bb en parallèle. Chaque branche comprend trois éléments électrochimiques connectés en série : E1a, E2a, E3a pour la branche Ba et E1b, E2b, E3b pour la branche Bb. Les éléments E2a, E3a, E1b, E2b et E3b possèdent une tension plus élevée que celle de l'élément E1a. Une résistance Rb est connectée aux bornes de chaque élément électrochimique. Un interrupteur S à l'état ouvert empêche la décharge de l'élément E1a dans la résistance Rb.
La figure 2 représente l'évolution de la tension des éléments électrochimiques du système d'équilibrage mis en oeuvre selon l'art antérieur représenté à la figure 1. Les éléments électrochimiques sont de type lithium-ion de capacité 45 Ah et les résistances sont de 43 Ohms.
La figure 3 représente un mode de réalisation du système d'équilibrage mis en oeuvre selon l'invention comprenant :
   - un système électronique Q comprenant un dispositif de mesure U de la tension de chaque élément électrochimique et un dispositif d'activation ou de désactivation S des résistances d'équilibrage;
   - un microprocesseur P qui récupère les mesures de tensions de chaque élément électrochimique et pilote via le système électronique Q l'activation ou la désactivation des résistances d'équilibrage.

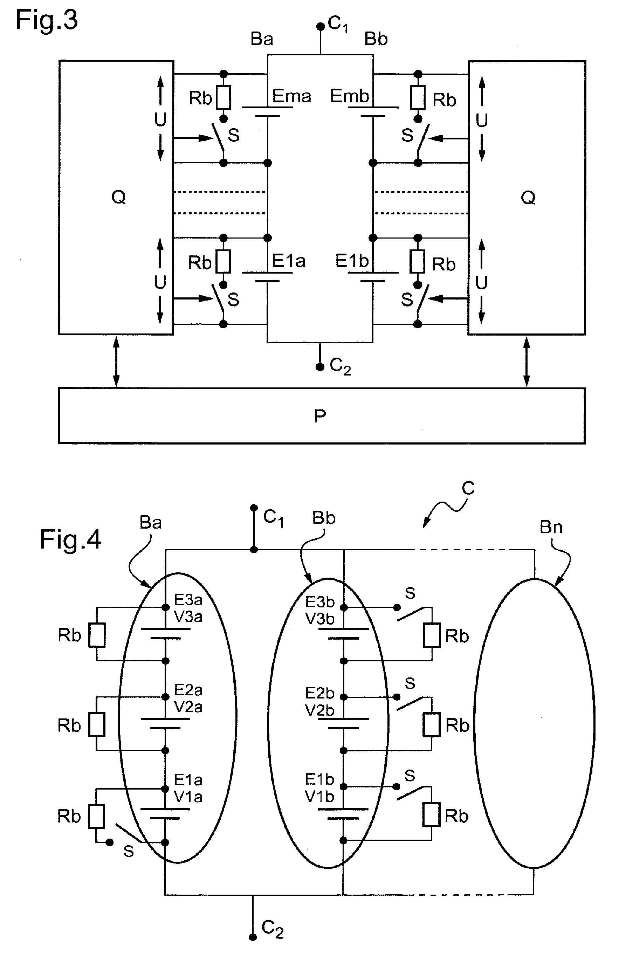

La figure 4 représente un système d'équilibrage mis en oeuvre selon l'invention dans lequel une batterie C comprend plusieurs branches Ba, Bb,.., Bn en parallèle. Chaque branche comprend trois éléments électrochimiques connectés en série : E1a, E2a, E3a pour la branche Ba et E1b, E2b, E3b pour la branche Bb. Les éléments E2a, E3a, E1b, E2b et E3b possèdent une tension plus élevée que celle de l'élément E1a. Une résistance Rb est connectée aux bornes de chaque élément électrochimique. Un interrupteur S à l'état ouvert empêche la décharge des éléments E1a, E1b, E2b, E3b dans leur résistance associée Rb.

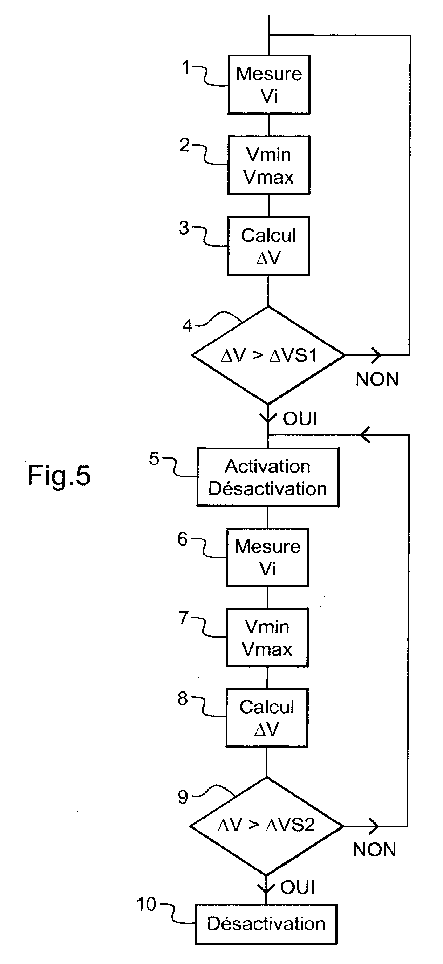

La figure 5 est un bloc diagramme représentant les différentes étapes du procédé selon l'invention dans lequel les étapes sont :
   1 - Mesure de la tension aux bornes de chaque élément électrochimique ;
   2 - Détermination de la tension minimale et maximale parmi l'ensemble des tensions mesurées ;
   3 - Calcul de la différence entre la tension minimale et maximale ΔV;
   4 - Comparaison de ΔV avec une valeur seuil prédéterminée ΔVs1 ;
   5 - Activation du ou des dispositif(s) de décharge ou de transfert d'énergie électrique situés dans la branche comprenant l'élément électrochimique possédant la tension la plus faible à l'exception du dispositif de décharge ou de transfert d'énergie électrique associé à l'élément électrochimique ayant la tension la plus faible ; et simultanément désactivation des dispositif de décharge ou de transfert d'énergie électrique connectés aux bornes des éléments électrochimiques du ou (des) branche(s) ne comprenant pas l'élément électrochimique ayant la tension la plus faible ;
   6 - Mesure de la tension aux bornes des différents éléments électrochimiques ;
   7 - Détermination de la tension minimale et maximale parmi l'ensemble des tensions mesurées ;
   8 - Calcul de la différence entre la tension minimale et maximale ΔV;
   9 - Comparaison de ΔV avec une valeur seuil prédéterminée ΔVs2 ;
   10 - Désactivation de tous les dispositifs de décharge ou de transfert d'énergie électrique.

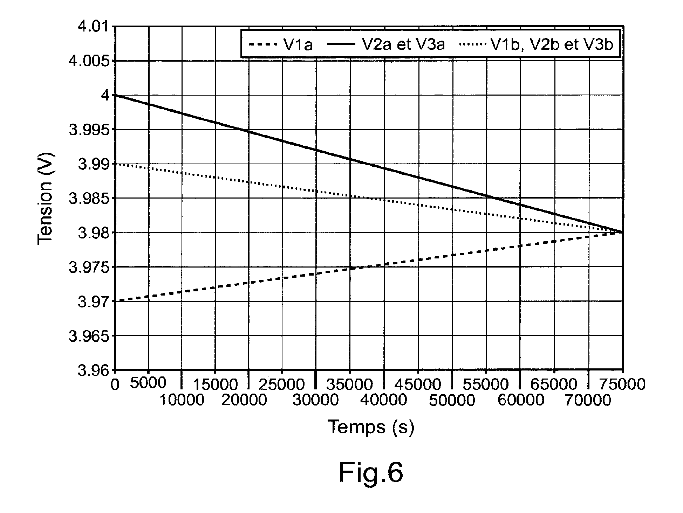

La figure 6 représente l'évolution de la tension des éléments électrochimiques du système d'équilibrage selon l'invention représenté à la figure 4. Les éléments électrochimiques sont de type lithium-ion de capacité 45 Ah et les résistances sont de 43 Ohms.

### EXPOSE DE MODES DE REALISATION

La figure 3 représente de manière générale une batterie à laquelle le procédé d'équilibrage selon l'invention peut être appliqué, m éléments électrochimiques (E1a, ..., Ema, E1b, ..., Emb) sont connectés en série et forment une branche du circuit, m étant supérieur ou égal à 2.

Dans un mode de réalisation, les tensions nominales des éléments électrochimiques sont identiques. Dans un mode de réalisation préféré, tous les éléments électrochimiques sont constitués du même couple électrochimique.

L'ensemble formé par les m éléments électrochimiques connectés en série forme une branche Ba ou Bb. Les différentes branches sont connectées en parallèle à un chargeur ou à une application aux points de connections C1 et C2. La batterie comprend donc au moins deux branches en parallèle. Dans un souci de simplification, seulement 2 branches en parallèle sont représentées figure 3, mais il est entendu que le nombre de branches en parallèle n'est pas limité à 2 mais peut prendre toute valeur au-delà de 2. Le système d'équilibrage est capable de gérer une batterie à branches multiples.

De même, le nombre d'éléments électrochimiques par branche n'est pas limité à 2 ou 3 mais peut prendre toute valeur au-delà de 3.

Les bornes de chaque élément électrochimique sont connectées à un dispositif de décharge ou de transfert d'énergie électrique Rb. Chaque dispositif de décharge ou de transfert d'énergie électrique peut être activé ou désactivé respectivement par la fermeture ou l'ouverture d'un interrupteur S ou d'un transistor placé en série avec celui-ci, qui selon sa position permet ou non le passage de courant dans le dispositif de décharge ou de transfert d'énergie électrique. Lorsque l'interrupteur est fermé, le dispositif de décharge ou de transfert d'énergie électrique est activé et l'élément électrochimique se décharge dans le dispositif de décharge ou alimente le dispositif de transfert d'énergie électrique. Inversement, lorsque l'interrupteur est ouvert, le dispositif de décharge est désactivé et l'élément électrochimique ne se décharge pas dans le dispositif de décharge ou n'alimente pas le dispositif de transfert d'énergie électrique.

Un premier système électronique Q comprend un dispositif de mesure U de la tension aux bornes de chaque élément électrochimique. Un second système électronique P, tel qu'un microprocesseur, calcule la différence entre la tension de l'élément le moins chargé et celle de l'élément le plus chargé ΔV Lorsque cette différence excède un certain seuil prédéterminé ΔVs1, cela signifie que le déséquilibre entre les tensions devient significatif et qu'un équilibrage est souhaité. On peut choisir dans le cas d'éléments électrochimiques au lithium une valeur pour ΔVs1 comprise en général entre 10 mV et 30 mV. Le circuit électronique P détermine pour chaque dispositif de décharge ou de transfert d'énergie électrique s'il doit être activé ou non. Il envoie un signal au premier système électronique Q qui :
i) met en position ouverte d'une part les interrupteurs placés en série avec les dispositifs de décharge ou de transfert d'énergie électrique connectés aux bornes des éléments électrochimiques de la branche ne comprenant pas l'élément électrochimique ayant la tension la plus faible et d'autre part, l'interrupteur placé en série avec le dispositif de décharge ou de transfert d'énergie électrique connecté à l'élément électrochimique ayant la tension la plus faible, et simultanément
ii) met en position fermée les interrupteurs placés en série avec les dispositifs de décharge ou de transfert d'énergie électrique connectés aux bornes des éléments électrochimiques de la branche comprenant l'élément électrochimique ayant la tension la plus faible, à l'exception de l'élément électrochimique ayant la tension la plus faible. Les systèmes électroniques P et Q peuvent être combinés en un seul système.

La figure 4 représente un exemple de mise en oeuvre du procédé d'équilibrage selon l'invention. Une batterie C comprend plusieurs branches Ba, Bb,..., Bn en parallèle. Chaque branche comprend trois éléments électrochimiques connectés en série : E1a, E2a, E3a pour la branche Ba et E1b, E2b, E3b pour la branche Bb. Les bornes de tous les éléments électrochimiques sont connectées à un dispositif de décharge ou de transfert d'énergie électrique Rb. Chaque dispositif de décharge ou de transfert d'énergie électrique peut être activé ou désactivé par la fermeture ou l'ouverture d'un interrupteur S placé en série avec celui-ci. Dans l'exemple de la figure 4, les éléments E2a, E3a, E1b, E2b et E3b possèdent une tension plus élevée que celle de l'élément E1a. La position ouverte ou fermée de chaque interrupteur est commandée par le système électronique Q non représenté.

Le procédé d'équilibrage fonctionne selon le principe suivant illustré à la Figure 5. A l'étape 1, on mesure grâce au dispositif de mesure du système électronique Q la tension aux bornes de chaque élément électrochimique. Les valeurs de tension de chaque élément électrochimique sont stockées dans une mémoire du système électronique P.

A l'étape 2, le système électronique P détermine la tension minimale et maximale de chaque élément électrochimique.

A l'étape 3, le système électronique P calcule la différence entre la tension minimale et maximale ΔV.

A l'étape 4, le système électronique P compare ΔV avec une valeur seuil prédéterminée ΔVs1. ΔVs1 est prédéterminé par l'utilisateur et définit la valeur limite de la dispersion admissible. Lorsque ΔV est inférieur à ΔVs1, on considère que l'étendue de la dispersion est admissible et on n'effectue pas d'équilibrage. Lorsque ΔV est supérieur à ΔVs1, on considère que l'étendue de la dispersion a dépassé la limite admissible et on effectue l'équilibrage.

A l'étape 5, l'équilibrage débute par l'activation par le système électronique Q des dispositifs de décharge ou de transfert d'énergie électrique situés dans la branche comprenant l'élément électrochimique possédant la tension la plus faible à l'exception du dispositif de décharge ou de transfert d'énergie électrique associé à l'élément électrochimique ayant la tension la plus faible qui reste désactivé simultanément avec la désactivation des dispositifs de décharge ou de transfert d'énergie électrique situés dans la branche ne comprenant pas l'élément électrochimique ayant la tension la plus faible ;

A l'étape 6, on mesure grâce au dispositif de mesure du système électronique Q la tension aux bornes des différents éléments électrochimiques ;

A l'étape 7, le système électronique P calcule la différence entre la tension minimale et maximale Δ2;

A l'étape 8, le système électronique P compare ΔV avec une valeur seuil prédéterminée ΔVs2. ΔVs2 est prédéterminée par l'utilisateur et définit la limite en dessous de laquelle on considère que les éléments sont équilibrés. Lorsque ΔV est supérieur à ΔVs2, on considère que la dispersion est trop importante et on poursuit l'équilibrage en allant à l'étape 5. Lorsque ΔV est inférieur à ΔVs2 on considère que la dispersion est suffisamment faible pour arrêter l'équilibrage et on désactive à l'étape 9 tous les dispositifs de décharge. La désactivation par le système électronique Q de tous les dispositifs de décharge interrompt l'équilibrage. Typiquement, on peut choisir pour ΔVs2 une valeur proche de l'incertitude sur le dispositif de mesure de la tension, par exemple entre 5 mV et 20 mV.

La mesure des tensions aux bornes de chaque élément électrochimique se fait de manière périodique. La périodicité des mesures dépend de la valeur de la résistance de décharge ou de l'impédance du dispositif de transfert d'énergie électrique. Plus la résistance du dispositif de décharge est faible, plus la décharge est rapide et plus l'intervalle de temps entre deux mesures est réduit. On peut utiliser par exemple une périodicité d'une seconde ou d'une minute.

L'évolution des tensions au cours de la phase d'équilibrage du dispositif de la figure 4 est représentée à la figure 6. L'équilibrage a été déclenché car la différence de tension entre la tension la plus faible et la tension la plus forte ΔV atteignait la valeur limite ΔVs1 de 30 mV. Pendant la phase d'équilibrage, la tension des éléments électrochimiques de la branche Bb baissent de 10 mV, la tension des éléments électrochimiques de la branche Ba les plus chargés baissent de 20 mV et l'élément électrochimique de la branche Ba ayant la tension la plus basse augmente de 10 mV. L'équilibrage s'interrompt lorsque la différence entre la tension la plus faible et la tension la plus forte ΔV atteint 0 mV.

On observe donc une recharge de l'élément le moins chargé. De manière générale, plus le nombre d'éléments électrochimiques dans la branche est grand, plus l'augmentation de tension de l'élément électrochimique ayant la tension la plus basse est importante.

Un des avantages du procédé est qu'il permet de réaliser un équilibrage branche par branche.

L'avantage du procédé selon l'invention est qu'il permet une recharge de l'élément électrochimique devant être rééquilibré. L'énergie libérée par les éléments les plus chargés n'est pas complètement perdue sous forme de chaleur. Une partie de l'énergie contenue dans les éléments électrochimiques les plus chargés est utilisée pour recharger l'élément électrochimique le moins chargé. Le système selon l'invention est donc plus intéressant du point de vue du rendement énergétique. Le système peut être qualifié de « semi-actif » puisque d'une part il recharge l'élément le moins chargé et d'autre part il décharge le ou les éléments les plus chargés de manière à ce que les tensions de tous les éléments de la batterie convergent vers la même valeur.

L'invention a également pour objet un produit de programme d'ordinateur comprenant au moins une séquence d'instructions stockées et accessibles à un processeur, où l'exécution du processeur conduit à la mise en oeuvre des étapes du procédé selon l'invention.

L'invention a également pour objet un support d'information lisible par un ordinateur, permettant de mettre en oeuvre au moins une des séquences d'instructions du produit de programme d'ordinateur. Le programme d'ordinateur peut être stocké sur un support d'information lisible par un ordinateur, tel que tout type de disque, disquettes souples, disques optiques, CD-ROMs, disque magnéto-optique, mémoires mortes « ROMs », mémoires vives «RAMs», mémoires mortes programmable électriquement (EPROMs), mémoires mortes programmable et effaçables électriquement (EEPROMs), cartes magnétiques et optiques, ou tout type de support approprié pour stocker des instructions électroniques, et capable d'être couplés à un bus système de l'ordinateur.

## Revendications

1. Procédé d'équilibrage d'une batterie (C) comprenant une pluralité de branches (Ba, Bb,..., Bn) en parallèle, chaque branche comprenant au moins deux éléments électrochimiques en série (E1a, E2a, E3a, E1b, E2b, E3b), un dispositif de décharge ou de transfert d'énergie électrique (Rb) activable, connecté aux bornes de chaque élément électrochimique, ledit procédé comprenant les étapes successives suivantes :
a) mesure de la tension aux bornes de chaque élément électrochimique (V1a, V2a, V3a, V1b, V2b, V3b) dans une configuration où tous les dispositifs de décharge ou de transfert d'énergie électrique ne sont pas activés ;
b) détermination de la tension la plus faible et de la tension la plus forte parmi l'ensemble des tensions mesurées à l'étape a);
c) calcul de la différence ΔV entre la tension la plus faible et la tension la plus forte de l'étape b);
d) si ΔV est supérieur à une valeur seuil prédéterminée ΔVs1 :
- activation du ou des dispositif(s) de décharge ou de transfert d'énergie électrique connectés aux bornes du ou des élément(s) électrochimique(s) de la branche comprenant l'élément électrochimique possédant la tension la plus faible, à l'exception du dispositif de décharge ou de transfert d'énergie électrique associé à l'élément électrochimique ayant la tension la plus faible, simultanément avec :
- désactivation des dispositifs de décharge ou de transfert d'énergie électrique connectés aux bornes des éléments électrochimiques du ou (des) branche(s) ne comprenant pas l'élément électrochimique ayant la tension la plus faible ;
e) mesure de la tension aux bornes de chaque élément électrochimique ;
f) détermination de la tension la plus faible et de la tension la plus forte parmi l'ensemble des tensions mesurées à l'étape e);
g) calcul de la différence entre la tension la plus faible et la tension la plus forte ΔV ;
h) si ΔV est inférieur à une valeur seuil prédéterminée ΔVs2, strictement inférieure à ΔVs1, désactivation de tous les dispositifs de décharge ou de transfert d'énergie électrique.

2. Procédé d'équilibrage selon la revendication 1, comprenant le suivi au cours du temps de la différence entre la tension la plus faible et la tension la plus forte et si cette différence ΔV est supérieure à ΔVs2 répétition des étapes d) à h).

3. Procédé d'équilibrage selon la revendication 1 ou 2, dans lequel le dispositif de décharge est une résistance.

4. Procédé d'équilibrage selon l'une des revendications 1 à 3, dans lequel l'activation du ou des dispositif(s) de décharge est obtenue à l'aide d'un interrupteur ou d'un transistor.

5. Procédé d'équilibrage selon l'une des revendications 1 à 3, dans lequel le dispositif de transfert de l'énergie électrique est choisi parmi une bobine et un condensateur.

6. Procédé d'équilibrage selon l'une des revendications précédentes, dans lequel au moins un élément électrochimique est au lithium, en particulier de type lithium-ion ou de type lithium polymère.

7. Batterie comprenant :
- une pluralité de branches (Ba, Bb,..., Bn) en parallèle, chaque branche comprenant au moins deux éléments électrochimiques en série (E1a, E2a, E3a, E1b, E2b, E3b) ;
- un dispositif de décharge ou de transfert d'énergie électrique (Rb) activable, connecté aux bornes de chaque élément électrochimique ;
- un dispositif de mesure de la tension de chaque élément électrochimique (V1a, V2a, V3a, V1b, V2b, V3b) ;
- un processeur configuré pour réaliser les étapes successives suivantes:
a) mesurer la tension aux bornes de chaque élément électrochimique dans une configuration où tous les dispositifs de décharge ou de transfert d'énergie électrique ne sont pas activés ;
b) déterminer la tension la plus faible et la tension la plus forte parmi l'ensemble des tensions mesurées à l'étape a);
c) calculer la différence ΔV entre la tension la plus faible et la tension la plus forte de l'étape b);
d) si ΔV est supérieur à une valeur seuil prédéterminée ΔVs1 :
- activer un ou des dispositif(s) de décharge ou de transfert d'énergie électrique connectés aux bornes du ou des élément(s) électrochimique(s) de la branche comprenant l'élément électrochimique possédant la tension la plus faible à l'exception du dispositif de décharge ou de transfert d'énergie électrique associé à l'élément électrochimique ayant la tension la plus faible, simultanément avec :
- désactiver des dispositifs de décharge ou de transfert d'énergie électrique connectés aux bornes des éléments électrochimiques du ou (des) branche(s) ne comprenant pas l'élément électrochimique ayant la tension la plus faible ;
e) mesurer la tension aux bornes de chaque élément électrochimique ;
f) déterminer la tension la plus faible et la tension la plus forte parmi l'ensemble des tensions mesurées à l'étape e);
g) calculer la différence entre la tension la plus faible et la tension la plus forte ΔV ;
h) si ΔV est inférieur à une valeur seuil prédéterminée ΔVs2, strictement inférieure à ΔVs1, désactiver tous les dispositifs de décharge ou de transfert d'énergie électrique.

8. Batterie selon la revendication 7, dans laquelle le processeur est configuré pour suivre au cours du temps la différence entre la tension la plus faible et la tension la plus forte et si cette différence ΔV est supérieure à ΔV2s, répéter les étapes d) à h) du procédé de la revendication 1, à l'exception du fait que l'étape d) ne comprend plus la comparaison de ΔV avec la valeur seuil prédéterminée ΔV1s.

9. Batterie selon la revendication 7 ou 8, dans laquelle le dispositif de décharge est une résistance.

10. Batterie selon l'une des revendications 7 à 9, dans laquelle l'activation du ou des dispositif(s) de décharge est obtenue à l'aide d'un interrupteur ou un transistor.

11. Batterie selon l'une des revendications 7 ou 8, dans laquelle le dispositif de transfert de l'énergie électrique est choisi parmi une bobine et un condensateur.

12. Batterie selon l'une des revendications 7 à 11, dans laquelle au moins un élément électrochimique est au lithium, en particulier de type lithium-ion ou de type lithium polymère.

13. Produit de programme d'ordinateur comprenant au moins une séquence d'instructions stockées et accessibles à un processeur, où l'exécution de ladite au moins une séquence d'instructions conduit à la mise en oeuvre des étapes du procédé de l'une quelconque des revendications 1 à 6.

14. Support d'information lisible par un ordinateur, permettant de mettre en oeuvre au moins une des séquences d'instructions du produit de programme d'ordinateur de la revendication 13.

## Patentansprüche

1. Verfahren zum Abgleich einer Batterie (C), die mehrere parallele Stränge (Ba, Bb, ..., Bn) umfasst, wobei jeder Strang mindestens zwei elektrochemische Elemente (E1a, E2a, E3a, E1b, E2b, E3b) in Reihe und eine aktivierbare Vorrichtung zur Entladung oder Übertragung elektrischer Energie (Rb) umfasst, die mit den Polen jedes elektrochemischen Elements verbunden ist, wobei das Verfahren die folgenden sukzessiven Schritte umfasst:
a) Messen der Spannung an den Polen jedes elektrochemischen Elements (V1a, V2a, V3a, V1b, V2b, V3b) in einer Konfiguration, in der alle Vorrichtungen zur Entladung oder Übertragung elektrischer Energie nicht aktiviert sind;
b) Bestimmen der niedrigsten Spannung und der höchsten Spannung aus der Gesamtheit der im Schritt a) gemessenen Spannungen;
c) Berechnen der Differenz ΔV zwischen der niedrigsten Spannung und der höchsten Spannung von Schritt b);
d) wenn ΔV höher als ein vorherbestimmter Grenzwert ΔVs1 ist:
- Aktivieren der Vorrichtung(en) zur Entladung oder Übertragung elektrischer Energie, die mit den Polen des bzw. der elektrochemischen Elemente des Strangs verbunden ist bzw. sind, der das elektrochemische Element umfasst, das die niedrigste Spannung aufweist, mit Ausnahme der Vorrichtung zur Entladung oder Übertragung elektrischer Energie, die mit dem elektrochemischen Element mit der niedrigsten Spannung assoziiert ist, gleichzeitig mit dem:
- Deaktivieren von Vorrichtungen zur Entladung oder Übertragung elektrischer Energie, die mit den Polen von elektrochemischen Elementen des bzw. der Stränge verbunden sind, der bzw. die nicht das elektrochemische Element mit der niedrigsten Spannung umfasst bzw. umfassen;
e) Messen der Spannung an den Polen jedes elektrochemischen Elements;
f) Bestimmen der niedrigsten Spannung und der höchsten Spannung aus der Gesamtheit der im Schritt e) gemessenen Spannungen;
g) Berechnen der Differenz ΔV zwischen der niedrigsten Spannung und der höchsten Spannung;
h) wenn ΔV niedriger als ein vorherbestimmter Grenzwert ΔVs2 ist, der strikt niedriger als ΔVs1 ist, Deaktivieren aller Vorrichtungen zur Entladung oder Übertragung elektrischer Energie.

2. Abgleichverfahren nach Anspruch 1, das die zeitliche Überwachung der Differenz zwischen der niedrigsten Spannung und der höchsten Spannung umfasst und wobei diese Differenz ΔV höher als ΔVs2 ist, unter Wiederholung der Schritte d) bis h).

3. Abgleichverfahren nach Anspruch 1 oder 2, wobei die Vorrichtung zur Entladung ein Widerstand ist.

4. Abgleichverfahren nach einem der Ansprüche 1 bis 3, wobei das Aktivieren der Vorrichtung(en) zur Entladung mittels eines Unterbrechers oder eines Transistors erzielt wird.

5. Abgleichverfahren nach einem der Ansprüche 1 bis 3, wobei die Vorrichtung zur Übertragung elektrischer Energie aus einer Spule und einem Kondensator ausgewählt ist.

6. Abgleichverfahren nach einem der vorhergehenden Ansprüche, wobei mindestens ein elektrochemisches Element aus Lithium, insbesondere vom Lithium-Ionen-Typ oder Lithium-Polymer-Typ ist.

7. Batterie, die Folgendes umfasst:
- mehrere parallele Stränge (Ba, Bb, ..., Bn), wobei jeder Strang mindestens zwei elektrochemische Elemente (E1a, E2a, E3a, E1b, E2b, E3b) umfasst;
- eine aktivierbare Vorrichtung zur Entladung oder Übertragung elektrischer Energie (Rb), die mit den Polen jedes elektrochemischen Elements verbunden ist;
- eine Vorrichtung zur Messung der Spannung jedes elektrochemischen Elements (V1a, V2a, V3a, V1b, V2b, V3b);
- einen Prozessor, der dazu konfiguriert ist, die folgenden sukzessiven Schritte umzusetzen:
a) Messen der Spannung an den Polen jedes elektrochemischen Elements in einer Konfiguration, in der alle Vorrichtungen zur Entladung oder Übertragung elektrischer Energie nicht aktiviert sind;
b) Bestimmen der niedrigsten Spannung und der höchsten Spannung aus der Gesamtheit der im Schritt a) gemessenen Spannungen;
c) Berechnen der Differenz ΔV zwischen der niedrigsten Spannung und der höchsten Spannung von Schritt b);
d) wenn ΔV höher als ein vorherbestimmter Grenzwert ΔVs1 ist:
- Aktivieren einer oder mehrerer Vorrichtungen zur Entladung oder Übertragung elektrischer Energie, die mit den Polen des bzw. der elektrochemischen Elemente des Strangs verbunden ist bzw. sind, der das elektrochemische Element umfasst, das die niedrigste Spannung aufweist, mit Ausnahme der Vorrichtung zur Entladung oder Übertragung elektrischer Energie, die mit dem elektrochemischen Element mit der niedrigsten Spannung assoziiert ist, gleichzeitig mit dem:
- Deaktivieren von Vorrichtungen zur Entladung oder Übertragung elektrischer Energie, die mit den Polen von elektrochemischen Elementen des bzw. der Stränge verbunden sind, der bzw. die nicht das elektrochemische Element mit der niedrigsten Spannung umfasst bzw. umfassen;
e) Messen der Spannung an den Polen jedes elektrochemischen Elements;
f) Bestimmen der niedrigsten Spannung und der höchsten Spannung aus der Gesamtheit der im Schritt e) gemessenen Spannungen;
g) Berechnen der Differenz ΔV zwischen der niedrigsten Spannung und der höchsten Spannung;
h) wenn ΔV niedriger als ein vorherbestimmter Grenzwert ΔVs2 ist, der strikt niedriger als ΔVs1 ist, Deaktivieren aller Vorrichtungen zur Entladung oder Übertragung elektrischer Energie.

8. Batterie nach Anspruch 7, wobei der Prozessor zum zeitlichen Überwachen der Differenz zwischen der niedrigsten Spannung und der höchsten Spannung konfiguriert ist und wobei diese Differenz ΔV höher als ΔVs2 ist, wobei die Schritte d) bis h) das Verfahrens nach Anspruch 1 wiederholt werden, mit der Ausnahme, dass der Schritt d) nicht mehr den Vergleich von ΔV mit dem vorherbestimmten Grenzwert ΔV1s umfasst.

9. Batterie nach Anspruch 7 oder 8, wobei die Vorrichtung zur Entladung ein Widerstand ist.

10. Batterie nach einem der Ansprüche 7 bis 9, wobei das Aktivieren der Vorrichtung(en) zur Entladung mittels eines Unterbrechers oder eines Transistors erzielt wird.

11. Batterie nach einem der Ansprüche 7 oder 8, wobei die Vorrichtung zur Übertragung elektrischer Energie aus einer Spule und einem Kondensator ausgewählt ist.

12. Batterie nach einem der Ansprüche 7 bis 11, wobei mindestens ein elektrochemisches Element aus Lithium, insbesondere vom Lithium-Ionen-Typ oder Lithium-Polymer-Typ ist.

13. Computerprogrammprodukt, das mindestens eine Sequenz von Befehlen umfasst, die gespeichert und für einen Prozessor zugänglich sind, wobei die Ausführung der mindestens einen Befehlssequenz zur Durchführung von Schritten des Verfahrens nach einem der Ansprüche 1 bis 6 führt.

14. Informationsträger, der durch einen Computer lesbar ist und der das Durchführen mindestens einer Befehlssequenz des Computerprogrammprodukts nach Anspruch 13 ermöglicht.

## Claims

1. A method for balancing a battery (C) comprising a plurality of branches (Ba, Bb, ..., Bn) in parallel, each branch comprising at least two electrochemical cells in series (E1a, E2a, E3a, E1b, E2b, E3b), an activatable electrical energy discharge or transfer device (Rb) connected across the terminals of each electrochemical cell, said method comprising the following successive steps:
a) measuring a voltage across each electrochemical cell (V1a, V2a, V3a, V1b, V2b, V3b) in a configuration where all the electrical energy discharge or transfer devices are not activated;
b) determining a lowest voltage and a highest voltage out of all the voltages measured in step a);
c) calculating a difference ΔV between the lowest voltage and the highest voltage from step b);
d) if ΔV exceeds a predetermined threshold value ΔVs1:
- activating the electrical energy discharge or transfer device(s) connected across the terminals of the cell(s) of that branch which includes the electrochemical cell having the lowest voltage with the exception of the electrical energy discharge or transfer device associated with the electrochemical cell having the lowest voltage, simultaneously with:
- deactivating the electrical energy discharge or transfer devices connected across the terminals of the cells of the branch or branches that do not include the electrochemical cell with the lowest voltage;
e) measuring a voltage across each electrochemical cell;
f) determining a lowest voltage and a highest voltage out of all the voltages measured in step e);
g) calculating a difference ΔV between the lowest voltage and the highest voltage;
h) if ΔV is less than a predetermined threshold value ΔVs2, strictly below ΔVs1, deactivating all discharge devices.

2. The balancing method according to claim 1, including monitoring over time a difference between lowest voltage and highest voltage and if this difference ΔV is greater than ΔVs2, repeating steps d) to h).

3. The balancing method according to claim 1 or 2, wherein the discharge device is a resistor.

4. The balancing method according to one of claims 1 to 3, wherein activation of said discharge device(s) is obtained by means of a switch or transistor.

5. The balancing method according to one of claims 1 to 3, wherein the electrical energy transfer device is selected from inductive winding means and a capacitor.

6. The balancing method as claimed in any preceding claim, wherein at least one electrochemical cell is a lithium cell, particularly of the lithium ion or lithium polymer type.

7. A battery comprising:
- a plurality of branches (Ba, Bb, ..., Bn) in parallel, each branch comprising at least two electrochemical cells in series (E1a, E2a, E3a, E1b, E2b, E3b);
- an activatable electrical energy discharge or transfer device (Rb) connected across the terminals of each electrochemical cell;
- a device for measuring a voltage of each electrochemical cell (V1a, V2a, V3a, V1b, V2b, V3b);
- a processor configured to perform the following successive steps:
a) measuring a voltage across each electrochemical cell in a configuration where all the electrical energy discharge or transfer devices are not activated;
b) determining a lowest voltage and a highest voltage out of all the voltages measured in step a);
c) calculating a difference ΔV between the lowest voltage and the highest voltage of step b);
d) if ΔV exceeds a predetermined threshold value ΔVs1:
- activating one or more electrical energy discharge or transfer device(s) connected across the terminals of the cell(s) in the branch that includes the electrochemical cell having the lowest voltage except for the electrical energy discharge or transfer device associated with the electrochemical cell having the lowest voltage, simultaneously with:
- deactivating the electrical energy discharge or transfer devices connected across the terminals of the cells in the branch or branches that do not include said electrochemical cell having the lowest voltage;
e) measuring a voltage across each electrochemical cell;
f) determining a lowest voltage and a highest voltage out of all the voltages measured in step e);
g) calculating a difference ΔV between the lowest voltage and highest voltage;
h) if ΔV is less than a predetermined threshold value ΔVs2, strictly below ΔVs1, deactivating all the electrical energy discharge or transfer devices.

8. The battery of claim 7, wherein the processor is configured to monitor over time a difference between lowest voltage and highest voltage and if this difference ΔV is greater than ΔV2s, repeating steps d) to h) of the method of claim 1, with the exception that step d) no longer includes comparing ΔV with the predetermined threshold value ΔV1s.

9. The battery of claim 7 or 8, wherein the discharge device is a resistor.

10. The battery according to one of claims 7 to 9, wherein activation of said electrical energy discharge device(s) is obtained by means of a switch or transistor.

11. The battery according to one of claims 7 or 8, wherein the electrical energy transfer device is selected from inductive winding means and a capacitor.

12. The battery according to one of claims 7 to 11, wherein at least one electrochemical cell is a lithium cell, particularly of the lithium ion or lithium polymer type.

13. A computer program product comprising at least one sequence of instructions stored and accessible to a processor, wherein execution thereof leads to the implementation of the method steps of any one of claims 1 to 6.

14. A computer-readable information carrier, allowing at least one of the sequences of instructions of the computer program product of claim 13 to be carried out.
